(19) Europäisches Patentamt

**European Patent Office**

Office européen des brevets

(11) Veröffentlichungsnummer: **0 162 120 B1**

(12) **EUROPÄISCHE PATENTSCHRIFT**

(45) Veröffentlichungstag der Patentschrift:
07.12.88

(21) Anmeldenummer: 84105425.7

(22) Anmeldetag: 14.05.84

(51) Int. Cl.⁴: **G 01 N 21/88, G 02 B 21/10**

(54) Verfahren und Einrichtung zur Oberflächenprüfung.

(43) Veröffentlichungstag der Anmeldung:
**27.11.85 Patentblatt 85/48**

(45) Bekanntmachung des Hinweises auf die Patenterteilung:
**07.12.88 Patentblatt 88/49**

(84) Benannte Vertragsstaaten:
**DE FR GB**

(56) Entgegenhaltungen:
EP-A- 0 011 709
WO-A-84/01212
DE-A- 2 462 111
US-A- 3 909 602

PATENTS ABSTRACTS OF JAPAN, Band 6, Nr.
148(P-133)[1026], 7. August 1982; & JP - A - 57 67844
(NIHON KOUGAKU KOGYO K.K.) 24.04.1982
IBM TECHNICAL DISCLOSURE BULLETIN, Band 23, Nr.
12, Mai 1981, Seiten 5422-5423, New York, US; D.
WAGNER: "High resolution optical surface
microtopography"
INSTRUMENTS AND CONTROL SYSTEMS, Band 40, Nr.
3, März 1967, Seiten 126-128; J.S. HOOD u.a.: "Surface
analyzer with digital display"

(73) Patentinhaber: **IBM DEUTSCHLAND GMBH,
Pascalstrasse 100, D-7000 Stuttgart 80 (DE)**

(84) Benannte Vertragsstaaten: **DE**

(73) Patentinhaber: **International Business Machines
Corporation, Old Orchard Road, Armonk,
N.Y. 10504 (US)**

(84) Benannte Vertragsstaaten: **FR GB**

(72) Erfinder: **Wagner, Dietmar, Kirchstrasse 9b,
D-7031 Gärtringen (DE)**

(74) Vertreter: **Barth, Carl Otto et al, IBM Deutschland GmbH
Patentabteilung Schönaicher Strasse 220,
D-7030 Böblingen (DE)**

## Beschreibung

Die Erfindung betrifft ein Verfahren zur Prüfung von Oberflächen nach dem Oberbegriff des Anspruchs 1 und eine Einrichtung zur Durchführung des Verfahrens nach dem Oberbegriff des Anspruchs 6. Die Erfindung wird bevorzugt zur Prüfung photolithographischer Masken und Halbleiterscheiben auf Fehlerfreiheit eingesetzt.

Die Inspektion von Oberflächen auf das Vorliegen von Defekten mit Durchmessern im Submikronbereich ist bei vielen modernen Fertigungsverfahren erforderlich; Beispiele hierfür bieten die Inspektion photolithographischer Masken, optischer Oberflächen oder der polierten Oberflächen von Halbleiterscheiben (Wafer).

Die Anforderungen an das verwendete Inspektionsgerät werden dabei insbesondere im Fall photolithographischer Masken immer grösser, da dort die regulären Strukturen der Maske selbst (z.B. Leiterzugbreite, Abstand der Leiterzüge usw.) in den Bereich von einem Mikrometer und darunter vorstossen. Sind die kleinsten von der Maske aufgelösten Strukturen beispielsweise 1,5 µm gross, so müssen Fehlstellen der Maske mit einem Durchmesser von 0,5 µm und mehr festgestellt werden; bei Strukturen von 0,75 µm sinkt entsprechend die Nachweisgrenze für Defekte auf 0,25 µm. Um eine hohe Ausbeute während des photolithographischen Prozesses zu gewährleisten, müssen alle verwendeten Masken auf Fehlerfreiheit in diesem Bereich geprüft werden, und zwar in regelmässigen Abständen, da sich durch abgesetzte Staubkörner und ähnliches laufend neue Defekte bilden können.

Das Auftreten neuer Defekte an einer schon geprüften Maske kann reduziert werden, wenn in einem Abstand von einigen Millimetern über der eigentlichen Maskenschicht eine durchsichtige Schutzfolie (ein sog. Pellikel) angebracht wird, auf der sich Staubkörner und andere Verunreinigungen absetzen können. Bei der Abbildung der Maske in lichtoptischen Systemen mit hoher Auflösung befindet sich diese Schutzfolie dann ausserhalb des sehr kleinen Schärfetiefenbereiches, so dass keine störende Abbildung der Schmutzteilchen erfolgt. Eine derartig geschützte Maske kann aber andererseits nicht mehr mit der notwendigen Auflösung auf Defektteilchen geprüft werden, die sich trotz der Schutzfolie auf der eigentlichen Maskenebene neu festgesetzt haben. Die geforderten hohen Auflösungen im Submikronbereich erfordern zur Inspektion nämlich optische Einrichtungen, z.B. Dunkelfeld-Mikroskope sehr hoher numerischer Apertur, deren Brennweite dann kleiner ist als der Abstand zwischen Maske und Schutzfolie. Ausserdem fällt bei modernen photolithographischen Masken mit ihren sehr kleinen Strukturen die Unterscheidung zwischen regelmässigen Mustern und Defektteilchen zunehmend schwerer. Bei der visuellen Inspektion derartiger Masken werden daher häufig Defekte übersehen; ausserdem ist diese sehr zeitaufwendig und für das Auge belastend.

Mit den bisher bekannten Verfahren und Einrichtungen zur Inspektion photolithographischer Masken können aus den oben genannten Gründen bei Masken mit Schutzfolien nur Defekte festgestellt werden, deren Durchmesser grösser als ungefähr 3 µm ist (obwohl bei Masken ohne Schutzfolie Partikel bis zu 0,5 µm erkennbar sind). Als Beispiele derartiger bekannter Einrichtungen seien genannt:

Optische Differenzverfahren, bei denen die zu überprüfende Maske gleichzeitig mit einer Referenzmaske abgetastet wird,

Verfahren mit digitaler Bildverarbeitung, bei denen die zu prüfende Maske in ein Digitalbild umgesetzt wird, das dann mit einem gespeicherten Digitalbild verglichen oder mit den Methoden der Bildverarbeitung analysiert wird.

Die vorliegende Erfindung stellt sich daher die Aufgabe, ein Prüfverfahren der eingangs genannten Art anzugeben, das insbesondere für die Inspektion photolithographischer Masken anwendbar ist, Defekte im Submikronbereich sicher erkennt und Aufschlüsse über deren ungefähren Durchmesser ermöglicht, schnell durchzuführen ist und automatisiert werden kann; ausserdem sollen Einrichtungen zur Durchführung des Verfahrens angegeben werden.

Diese Aufgabe wird durch die in den Ansprüchen 1 und 6 gekennzeichnete Erfindung gelöst; Ausgestaltungen der Erfindung sind in den abhängigen Ansprüchen gekennzeichnet.

Der Grundgedanke der hier vorliegenden Erfindung besteht darin, eine Oberfläche unter zwei verschiedenen Beleuchtungsarten zu beobachten und die beiden erzeugten Bilder miteinander zu vergleichen. Da sich die optischen Eigenschaften, z.B. das Streuvermögen der Defektstellen von denen der regulären Strukturen der Maske unterscheiden, kann durch diesen Vergleich eine eindeutige Bestimmung von Defekten erfolgen. Als bevorzugte Beleuchtungsarten bei transparenten Körpern werden einerseits das Auflicht-Dunkelfeld verwendet, in dem die regulären Strukturen (z.B. Kanten) bevorzugt erscheinen und andererseits das Durchlicht-Dunkelfeld, das die Defektstellen betont. Zur Bestimmung der Bildunterschiede in den beiden Beleuchtungsarten kann die Maske nacheinander von einer Fernsehkamera aufgenommen werden (bei entsprechend genauer Justierung), um anschliessend eine digitale Bildverarbeitung durchzuführen. In einer anderen Ausführungsform wird die Maske von einem fokussierten Laserstrahl abgetastet und gleichzeitig das an jeden Punkt in Reflexion und in Transmission erzeugte Dunkelfeld-Signal registriert und elektronisch ausgewertet. Bei undurchsichtigen Körpern mir reflektierenden Oberflächen werden Auflicht-Dunkelfeld-Aufnahmen unter verschiedenen Beobachtungswinkeln erzeugt.

Die Einrichtungen zur Durchführung des Verfahrens erlauben eine automatische Inspektion mit relativ kurzen Verarbeitungszeiten. Bei der Laserabtastung sind auch für Masken mit Schutzfolien Defekte von ungefähr 0,3 µm auflösbar.

Die Erfindung macht von einigen Massnahmen Gebrauch, die an sich und für andere Zwecke im Stand der Technik bekannt sind: so beschreibt DE-A-2 462 111 die punktweise Subtraktion (z.B. auf elektrischem Weg) zweier unterschiedlich erzeugter Bilder desselben Gegenstandes als ein Schritt in einem Verfahren zur Kontrastverbesserung sowie zur Steigerung der förderlichen Vergrösserung (Auflösungsvermögen) eines optischen Mikroskops, mit dem hochauflösende Bilder lebender Untersuchungsobjekte hergestellt werden sollen. Dieses Verfahren ist zur effizienten und genauen Lokalisierung von Defektstellen auf einer Oberfläche wenig oder gar nicht geeignet.

Ausführungsbeispiel der Erfindung werden nun anhand von Zeichnungen näher erläutert. Es zeigen:

Fig. 1 den prinzipiellen Strahlenverlauf bei der Auflicht-Dunkelfeld- und Durchlicht-Dunkelfeld-Inspektion einer photolithographischen Maske mit einer Schutzfolie,

Fig. 2A ein Beispiel für eine Auflicht-Dunkelfeld-Aufnahme einer photolithographischen Maske,

Fig. 2B eine Durchlicht-Dunkelfeld-Aufnahme der gleichen Maske wie in Fig. 2A,

Fig. 3 die schematische Darstellung eines Ausführungsbeispiels der vorliegenden Erfindung mit einem die Maske abtastenden fokussierten Laserstrahlenbündel,

Fig. 4 ein Beispiel für einen Schwingspiegel hoher Ablenkfrequenz für eine Abtastanordnung nach Fig. 3,

Fig. 5 ein weiteres Ausführungsbeispiel der vorliegenden Erfindung mit digitaler Verarbeitung der Durchlicht-Dunkelfeld- und der Auflicht-Dunkelfeld-Bilder einer photolithographischen Maske,

Fig. 6 die schematische Darstellung einer weiteren Ausführungsform der Erfindung, in der die reflektierende Oberfläche eines undurchsichtigen Körpers auf Defektstellen untersucht wird.

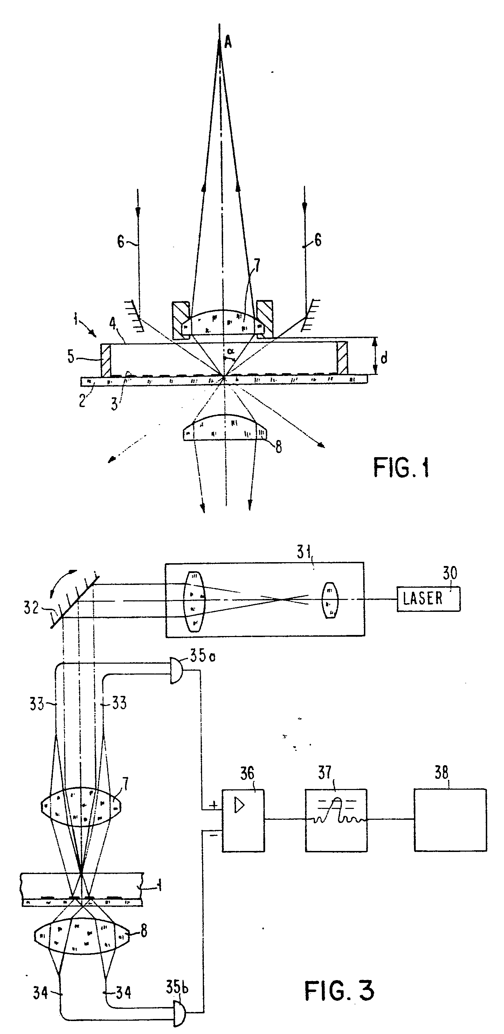

Fig. 1 zeigt den prinzipiellen Strahlenverlauf bei der hier vorgeschlagenen optischen Inspektion einer photolithographischen Maske 1, bestehend aus einem durchsichtigen Substratträger 2 mit einem darauf niedergeschlagenen undurchsichtigen Muster, beispielsweise aus Chrom, und einer Schutzfolie 4, die im Abstand von einigen Millimetern über der Maske durch einen Ring 5 getragen wird. Die kleinsten charakteristischen Abmessungen des Chrommusters 3 liegen bei heutigen Masken bei 1,5 µm und darunter. Die Inspektion derartiger Masken auf Fehlerfreiheit erfolgt immer noch hauptsächlich visuell, wobei als bevorzugte Beleuchtungsanordnung die Auflicht-Dunkelfeld-Beleuchtung gewählt wird. Dazu wird das von schräg auf die Maskenoberfläche auftreffenden Lichtstrahlen 6 gestreute Licht in einem Mikroskopobjektiv 7 gesammelt. Der minimale Arbeitsabstand d des Objektivs 7 von der scharf abzubildenden Oberfläche des Substrats 2 ist bei einer Maske mit einer Schutzfolie durch die Höhe des Ringes 5 bestimmt, die im allgemeinen einige Millimeter beträgt. Bei einem grossen Arbeitsabstand d (und einer entsprechend grossen Brennweite des Objektivs 7) ergibt sich aber eine relativ kleine numerische Apertur N.A. = $\sin\alpha$; dadurch ist wiederum das Auflösungsvermögen bei der Abbildung durch das Objektiv 7 begrenzt, d.h. der Abstand $\Delta x$ zweier noch als getrennt erscheinender Punkte, der durch das sogenannte Rayleigh-Kriterium bestimmt ist:

$$\Delta x = \frac{0,61 \cdot \lambda}{\text{N.A.}}$$

Eine für die Auflösung von Defektpartikeln mit Durchmessern von ungefähr 0,3 µm ausreichende Apertur würde andererseits Arbeitsabstände von nur $\gtrsim$ 1 mm erfordern.

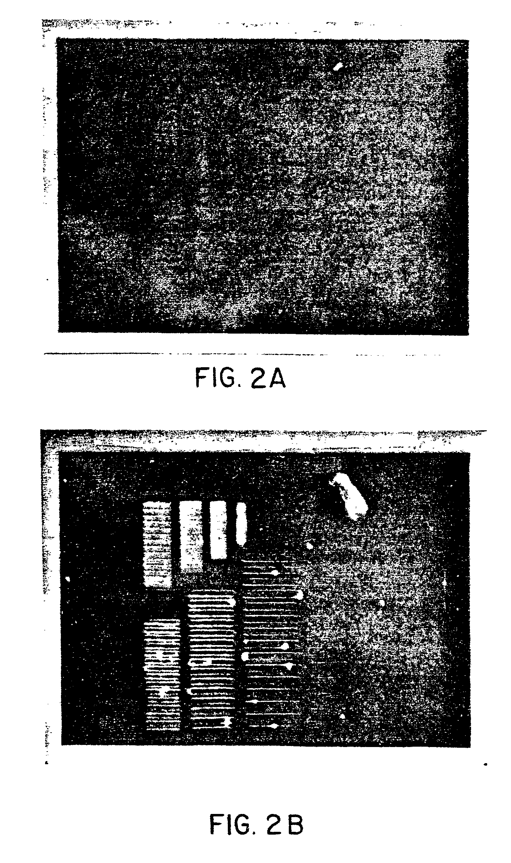

Fig. 2A zeigt eine Aufnahme einer photolithographischen Maske mit der eben beschriebenen Auflicht-Dunkelfeld-Beleuchtung bei relativ kleiner Vergrösserung. Die regulären Strukturen der Maske, im wesentlichen die Kanten, erscheinen bei dieser Beleuchtungsart sehr deutlich, während die (punktförmigen) Defekte nur schwer erkennbar sind.

Der unter der Glasplatte 2 dargestellte Teil von Fig. 1 zeigt den prinzipiellen Strahlengang für eine zweite Beleuchtungsart, die sog. Durchlicht-Dunkelfeld-Beleuchtung. Ein Objektiv 8 sammelt dazu das von streuenden Elementen auf der Oberfläche der Glasplatte 2 gestreute Licht, das durch die Platte 2 selbst hindurchtritt. Das zur Beleuchtung verwendete Licht (entsprechend den Strahlen 6) geht dagegen am Objektiv 8 vorbei.

Wird nun dieselbe Maske wie in Fig. 2A mit der Durchlicht-Dunkelfeld-Anordnung aufgenommen, so ergibt sich Fig. 2B, in der die regulären Strukturen der Maske weniger stark betont sind, dafür aber die Maskendefekte als sehr hell leuchtende Punkte erscheinen. Auch die Aufnahme von Fig. 2B ist mit derselben Vergrösserung ($\sim$ 500) und etwas grösserer Apertur als Fig. 2A aufgenommen.

Der augenfällige Unterschied zwischen den beiden Aufnahmen in Fig. 2A bzw. Fig. 2B beruht auf der verschiedenartigen optischen Streuung an Kanten einerseits und an kleinen Partikeln andererseits. Die letzteren zeigen abhängig von der Partikelgrösse eine deutliche Vorwärtsstreuung (sog. Mie-Streuung), die sich im Durchlicht-Dunkelfeld besonders bemerkbar macht.

Zur bequemen und insbesondere zur automatischen Auswertung der verschiedenen streuenden Zentren und damit zur Unterscheidung zwischen regulären Maskenstrukturen und Defekten werden die Auflicht-Dunkelfeld- und die Durchlicht-Dunkelfeld-Aufnahmen voneinander subtrahiert. Ergeben sich dabei starke lokale Differenzen, so weisen diese auf Defektpartikel hin. Aus der Grösse der Differenzen kann auch ungefähr auf die Defektgrösse geschlossen werden (da bei kleinen Partikeln deren Streuverhalten von der Partikelgrösse abhängt).

Für den hier vorgeschlagenen Vergleich können im Prinzip die im Stand der Technik bekannten Verfahren eingesetzt werden, mit denen Unterschiede zweier Bilder feststellbar sind. Dazu gehören beispielsweise rein optische Verfahren, bei denen die beiden Bilder übereinander projiziert werden, entweder gleichzeitig mit jeweils verschiedenfarbiger Beleuchtung (und somit farbiger Hervorhebung der nicht identischen Bildstellen) oder abwechselnd, um nichtidentische Bildstellen als flimmernde Punkte erkennen zu können. Auch digitale Verarbeitungsverfahren sind möglich, bei denen beide Bilder digitalisiert und der anschliessende Vergleich rechnerisch mit den ermittelten Farb- oder Grauwerten durchgeführt wird.

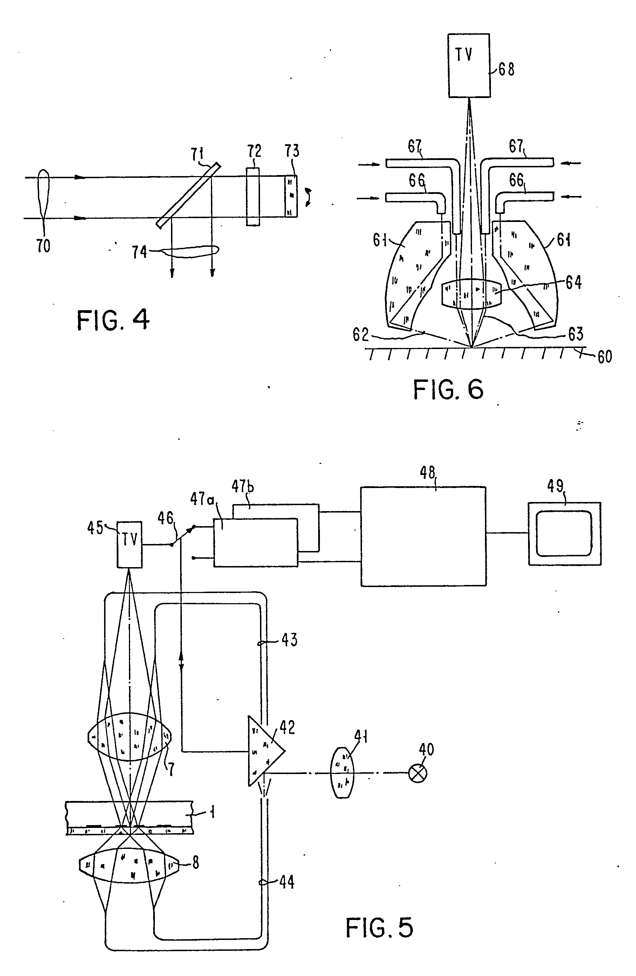

Besonders vorteilhafte Einrichtungen zur Durchführung des hier vorgeschlagenen Komparatorverfahrens sind in den Fign. 3 und 5 schematisch dargestellt. Nach Fig. 3 wird die Maske mit Schutzfolie 1 punktweise von einem fokussierten Laserstrahl abgetastet, der von einem Laser 30 ausgeht und nach Durchlaufen einer Strahlaufweitungseinheit 31 an einem oszillierenden Spiegel 32 in das fokussierende Objektiv 7 abgelenkt wird. Zum Auffangen des an der Maskenoberfläche gestreuten, reflektierten Lichtes dienen Lichtwellenleiter (optische Fasern) 33, die ringförmig so hinter dem Objektiv 7 angeordnet sind, dass sie nur das nicht regulär reflektierte Licht aufnehmen können, das durch das Objektiv tritt. Ein Mikroskopobjektiv mit einer derartigen Anordnung von Lichtwellenleitern ist beispielsweise in der EP-A-11 709 beschrieben. Alle Lichtwellenleiter 33 werden zu einer Photodiode 35a geführt, deren Ausgangssignal als Eingang für einen Differenzschaltkreis 36 dient. Unter der Maske 31 befindet sich entsprechend Fig. 1 ein zweites Objektiv 8, das ebenfalls mit einer ringförmigen Anordnung von Lichtwellenleitern 34 ausgestattet ist.

Zur Änderung des Beleuchtungswinkels können die Enden der Lichtleitfasern parallel zur optischen Achse der Objektive verschoben werden. Andere Arten der Dunkelfeld-Beleuchtung, z.B. mit Spiegeln, sind ebenfalls möglich.

Der Beleuchtungswinkel für die Dunkelfeld-Beleuchtung sollte einstellbar sein, um den bestmöglichen Kontrast zwischen Auflicht- und Durchlicht-Aufnahme auffinden zu können. Ein Beleuchtungswinkel nahe dem Dunkelfeld-Beobachtungswinkel wird in vielen Fällen einen guten Kontrast ergeben.

Die Lichtwellenleiter 34 sind zu einer Photodiode 35b geführt, die ein zweites Ausgangssignal für den Differenzschaltkreis 36 liefert. Das Ausgangssignal des Schaltkreises 36 wird zu einer Schwellwertschaltung 37 geführt, die feststellt, ob die Differenz der optischen Signale des gerade abgetasteten Punktes einen bestimmten einstellbaren Wert überschreitet und somit auf das Vorliegen eines Defektes hindeutet. Festgestellte Defekte können dann in einem Speicher 38 markiert werden, der entsprechend der jeweiligen Position des fokussierten Laserstrahls auf der Maskenoberfläche adressiert wird.

Die Abtastung der Maske erfolgt rasterförmig, entweder mit zwei hintereinander geschalteten Schwingspiegeln 32 oder mit einem einzelnen Spiegel 32 und mechanischer Verschiebung der Maske 1 in der dazu senkrechten Koordinatenrichtung.

Bei der Einrichtung nach Fig. 3 werden also nicht zwei Bilder hintereinander aufgenommen, sondern von jedem einzelnen Punkt der Maske gleichzeitig das Auflicht-Dunkelfeld- und das Durchlicht-Dunkelfeld-Signal ermittelt. Die hohe Beleuchtungsstärke, die bei Verwendung eines Lasers zur Verfügung steht, ergibt ein sehr gutes Signal/Rauschverhältnis, das durch Verwendung von empfindlichen Photovervielfachern anstelle der Photodioden 35 noch gesteigert werden kann. Da die Empfindlichkeit des Verfahrens im wesentlichen vom Signal/Rauschverhältnis bestimmt wird (und nicht durch das optische Auflösungsvermögen), lassen sich Defekte mit einer Grösse bis zu ungefähr 0,3 µm erkennen; ausserdem kann eine Grobklassifizierung der Partikelgrösse entsprechend der Grösse des Ausgangssignals erfolgen.

Die zur vollständigen Prüfung einer Maske (die Durchmesser bis zu 10 cm aufweisen kann) erforderliche Zeit hängt im wesentlichen von der Ablenkfrequenz des Schwingspiegels 32 ab. Diese Frequenz ist durch die natürliche Resonanz der Oszillation und damit durch die bewegte Masse des Spiegels bestimmt und liegt bei maximal 4 kHz. Eine Verdoppelung der Oszillationsfrequenz lässt sich erzielen, wenn zur Umlenkung des Laserbündels um ungefähr 90° nicht ein Schwingspiegel verwendet wird, der in der Winkelhalbierenden orientiert ist, sondern senkrecht zum einfallenden Bündel. Der Spiegeldurchmesser wird dann um den Faktor $\sqrt{2}$ kleiner und somit die Spiegelmasse um den Faktor 2.

Fig. 4 zeigt eine derartige Anordnung, mit der ein (polarisiertes) Laserbündel 70 in die Richtung 74 abgelenkt werden kann. Dazu durchläuft das Bündel 70 zuerst einen polarisierenden Strahlenteiler 71, der unter 45° zur Bündelachse angeordnet ist und gelangt über eine λ/4-Platte 72 zur reflektierenden Oberfläche des Schwingspiegels 73, der nur so gross gewählt werden muss, dass er das gesamte einfallende Bündel 70 reflektiert. Das reflektierte Licht wird am Strahlteiler 70 abgelenkt, da es die λ/4-Platte 72 zweimal durchlaufen hat und somit seine Polarisationsrichtung um 90° gedreht wurde. Bei der hier betrachteten Anwendung sind die Auslenkwinkel des Schwingspiegels 73 klein (ungefähr 7°), so dass auch bei maximaler Auslenkung keine Störungen des Strahlenganges durch schiefe Winkel zu befürchten sind.

Fig. 5 zeigt ein weiteres Beispiel für eine automatische Einrichtung zur Maskeninspektion; ihr optischer Aufbau entspricht im wesentlichen Fig. 1. Die schräg einfallenden Lichtbündel für die Durchlicht-Dunkelfeld-Beleuchtung und die Auflicht-Dunkelfeld-Beleuchtung werden durch Lichtwellenleiter 43 bzw. 44 erzeugt, die wie im Fall der Fig. 3 ringförmig um die Objektive 7 und 8 angeordnet sind. Zwischen der Durchlicht-Dunkelfeld- und der Auflicht-Dunkelfeld-Beleuchtung wird periodisch abgewechselt, beispielsweise indem jeweils die Gruppe der Lichtwellenleiter 43 oder die Gruppe der Lichtwellenleiter 44 in den Strahlengang einer Lampe 40 mit vorgeschalteter Linse 41 gebracht werden. Dieses Umschalten kann entsprechend Fig. 5 durch ein Prisma 42 erfolgen, das nach oben bzw. nach unten verschoben wird und an dessen verspiegelten Seitenflächen das Licht der Lampe in die jeweiligen Lichtwellenleiter reflektiert wird. Die Enden der Lichtwellenleiter liegen auch hier hinter der Abbildungsoptik (7 bzw. 8), so dass das austretende Licht durch die Optik hindurchtritt.

Die Beobachtung der beiden Dunkelfeld-Bilder erfolgt durch eine Fernsehkamera 45, die über einen Wechselschalter 46 wahlweise mit einem von zwei Bildspeichern 47a, 47b verbunden werden kann. Die Stellung des Wechselschalters 46 ist mit der Stellung des Ablenkprismas 42 synchronisiert. Die in den Speichern 47 enthaltenen beiden digitalen Bilder können dann zur Auswertung an ein Bildverarbeitungsgerät 48 gegeben werden, das mit den bekannten digitalen Verarbeitungsmethoden lokale Bildunterschiede feststellen kann. Hierzu eignet sich beispielsweise ein entsprechend programmierter Rechner 48, dessen Ergebnisse auf einem Anzeigemonitor 49 wiedergegeben werden.

Bei der Anordnung nach Fig. 5 muss sichergestellt sein, dass sich die Maske in der Zeit zwischen den beiden Aufnahmen mit unterschiedlicher Beleuchtung nicht bewegt, da sonst Maskendefekte vorgetäuscht werden können. Die optische Auflösung der Anordnung nach Fig. 5 ist geringer als bei Verwendung eines abtastenden fokussierten Laserstrahls, doch können bei gutem Signal/Rauschverhältnis im Videosignal auch noch Partikel erkannt werden, die unter der eigentlichen optischen Auflösung liegen; diese erhöhen nämlich den lokalen Signalpegel, so dass diese Signale von anderen Signalen getrennt werden können, wenn ein genügend hohes Signal/Rauschverhältnis vorliegt. Der Vorteil der Anordnung nach Fig. 5 besteht darin, dass zur Auswertung der Bildunterschiede auf bekannte digitale Verfahren und elektronische Einrichtungen zurückgegriffen werden kann.

Das bisher am Beispiel der Prüfung von Oberflächen durchsichtiger Körper beschriebene Verfahren lässt sich auch auf Oberflächen undurchsichtiger Körper anwenden; dazu wird anstelle der Durchlicht-Dunkelfeld-Aufnahme eine weitere Auflicht-Dunkelfeld-Aufnahme erzeugt und dabei der Einfallswinkel des beleuchtenden Lichtes gegenüber der ersten Aufnahme verändert. Reguläre Strukturen, z.B. Kanten, und Defektstellen, z.B. Staubkörner, unterscheiden sich deutlich in ihrem Streuverhalten bei geeignet gewählten Beleuchtungsarten, so dass wieder durch Subtraktion der entstehenden Dunkelfeld-Aufnahmen Defektstellen erkannt werden können.

Fig. 6 zeigt ein Beispiel einer Einrichtung zur Prüfung der Oberfläche undurchsichtiger Körper nach dem hier vorgeschlagenen Verfahren. Von der Oberfläche 60, beispielsweise der polierten Oberfläche einer Halbleiterscheibe (Wafer) werden abwechselnd zwei Auflicht-Dunkelfeld-Aufnahmen erzeugt, die über das Objektiv 64 auf eine Fernsehkamera 68 zur weiteren Verarbeitung (Subtraktion) abgebildet werden. Die beiden Auflicht-Dunkelfeld-Beleuchtungen 62 und 63 unterscheiden sich in ihrem Einfallswinkel und werden von ringförmig um die optische Achse angeordneten Lichtwellenleitern 66 bzw. 67 erzeugt. Die Lichtwellenleiter 67 für die spitzwinklig auftreffende Dunkelfeld-Beleuchtung 63 ist hinter dem Abbildungsobjektiv 64 angeordnet. Die unter grossem Winkel auf der Oberfläche 60 auftreffende Dunkelfeld-Beleuchtung 62 tritt aus ringförmig um die optische Achse angeordneten Lichtwellenleitern 66 aus und gelangt in einen Kardioidkondensor 61, in dem die Lichtbündel mehrfach reflektiert werden, bis sie bei ihrem Austritt den gewünschten Neigungswinkel zur optischen Achse aufweisen.

Die beiden Eintrittswinkel für die Dunkelfeld-Beleuchtungen werden so gewählt, dass sich für reguläre Strukturen (z.B. Kanten) einerseits und Defektteilchen andererseits möglichst grosse Differenzen in den beiden Dunkelfeld-Aufnahmen ergeben. Die Auswertung der Aufnahmen erfolgt in der früher beschriebenen Weise.

## Patentansprüche

1. Verfahren zur Prüfung von Oberflächen auf Defektstellen mit Abmessungen im Mikrometer-Bereich unter Verwendung einer Dunkelfeld-Beleuchtung, dadurch gekennzeichnet, dass für jeden Punkt der Oberfläche die bei Auflicht-Dunkelfeld-Beleuchtung ausgehende Lichtintensität von der Lichtintensität subtrahiert wird, die bei einer weiteren Dunkelfeld-Beleuchtung mit anderen optischen Parametern ausgeht, und dass die Differenz einer Schwellwertoperation unterzogen wird.

2. Verfahren nach Anspruch 1, dadurch gekennzeichnet, dass der Differenzbetrag der Lichtintensität als Mass für die Grösse der Defektstelle herangezogen wird.

3. Verfahren nach Anspruch 1 oder 2, dadurch gekennzeichnet, dass bei der Prüfung der Oberflächen durchsichtiger Körper die weitere Dunkelfeld-Beleuchtung in Durchlicht durchgeführt wird.

4. Verfahren nach Anspruch 3, gekennzeichnet, durch seine Verwendung zur Prüfung photolithographischer Transparentmasken auf Freiheit von niedergeschlagenen Störpartikeln.

5. Verfahren nach Anspruch 1 oder 2, dadurch gekennzeichnet, dass die weitere Dunkelfeld-Beleuchtung in Auflicht unter einem Beleuchtungswinkel durchgeführt wird, der sich von dem der ersten Auflicht-Dunkelfeld-Beleuchtung unterscheidet.

6. Einrichtung zur Prüfung von Oberflächen auf Defektstellen mit Abmessungen im Mikrometer-Bereich, in der Vorrichtungen (6; 33) zur Erzeugung einer Auflicht-Dunkelfeld-Beleuchtung vorgesehen sind, gekennzeichnet durch:
– Vorrichtungen (8; 34) zur Erzeugung einer weiteren Dunkelfeld-Beleuchtung, deren optische Parameter von denen der Auflicht-Dunkelfeld-Beleuchtung unterschiedlich sind,
- Vorrichtungen (36) zur Subtraktion der beiden Lichtintensitäten, die jeder Bildpunkt unter dem Einfluss beider Dunkelfeld-Beleuchtungen aussendet und
- Vorrichtungen zur Durchführung einer Schwellwert-Operation für die Differenz der Lichtintensitäten.

7. Einrichtung nach Anspruch 6, dadurch gekennzeichnet, dass die Vorrichtungen zur Dunkelfeld-Beleuchtung Lichtleitfasern (43, 44, 66, 67) darstellen, deren Enden ringförmig zur optischen Achse des Abbildungssystems (7, 8) angeordnet sind.

8. Einrichtung nach Anspruch 7, dadurch gekennzeichnet, dass eine Videokamera (45) abwechselnd beide Dunkelfeld-Aufnahmen der Oberfläche registriert und dass eine digitale Bildverarbeitungseinrichtung (48) die digitalisierten Intensitäten jedes Bildpunktes subtrahiert.

9. Einrichtung nach Anspruch 6, dadurch gekennzeichnet, dass die zu untersuchende Oberfläche rasterförmig von einem Laserstrahl abgetastet wird, der von einer Fokussierungsoptik (7) auf die Oberfläche fokussiert wird, und dass gleichzeitig das Auflicht-Dunkelfeld-Signal und das Durchlicht-Dunkelfeld-Signal jedes Bildpunktes Photodetektoren (35a, 35b) zugeführt wird, die Ausgangssignale für eine Differenzschaltung (36) mit einer nachgeschalteten Schwellwertschaltung (37) erzeugen.

10. Einrichtung nach Anspruch 9, dadurch gekennzeichnet, dass die Dunkelfeld-Signale des untersuchten Bildpunktes über Lichtleitfasern (33, 34) zu den Photodetektoren (35) transportiert werden und dass die Enden der Lichtleitfasern ringförmig so hinter der Fokussierungsoptik (7) angeordnet sind, dass das Auflicht-Dunkelfeld-Licht durch die Fokussierungsoptik hindurchtritt.

11. Einrichtung nach Anspruch 7 oder 8, dadurch gekennzeichnet, dass der Wert des Ausgangssignals der Schwellwertschaltung (37) in einem Digitalspeicher (38) abgelegt wird. der entsprechend der momentanen Position des abtastenden Laserstrahlenbündels adressiert wird.

12. Einrichtung nach einem der Ansprüche 9 bis 11, dadurch gekennzeichnet, dass zur Ablenkung eines linear polarisierten Strahlenbündels (40) ein im wesentlichen senkrecht zur Bündelachse orientierter Schwingspiegel (43) vorgesehen ist, dem ein unter 45° zur Bündelachse orientierter polarisierender Strahlenteiler (41) und ein $\lambda/4$-Plättchen (42) vorgeschaltet sind.

## Claims

1. Method of testing surfaces for defects with dimensions in the micrometer range, using darkfield illumination, characterized in that for each point of the surface, the light intensity generated by with darkfield reflection illumination is subtracted from the light intensity generated by another darkfield illumination with other optical parameters, and that the difference is subjected to a threshold operation.

2. Method is claimed in Claim 1, characterized in that the difference of light intensity is referred to as a measure for the size of the defect.

3. Method as claimed in any one of Claims 1 or 2, characterized in that for testing the surfaces of transparent bodies the further darkfield illumination is effected in the transmission mode.

4. Method as claimed in Claim 3, characterized by its use for testing photolithographic transparent masks for the absence of defect particles.

5. Method as claimed in any one of Claims 1 or 2, characterized in that the further darkfield illumination is effected in the reflection mode under an angle of illumination which differs from that of the first darkfield reflection illumination.

6. Arrangement for testing surfaces for defects with dimensions in the micrometer range, with devices (6; 33) for generating a darkfield reflection illumination, characterized by:
- devices (8; 34) for generating another darkfield illumination whose optical parameters differ from those of the darkfield reflection illumination,
- devices (36) for subtracting the two light intensities emitted by each image point under the influence of both darkfield illuminations, and
- devices for carrying out a threshold operation for the light intensity differences.

7. Arrangement as claimed in Claim 6, characterized in that the devices for the darkfield illumination represent optical fibers (43, 44, 66, 67) whose ends are arranged annularly relative to the optical axis of the imaging system (7, 8).

8. Arrangement as claimed in Claim 7, characterizd in that a video camera (45) alternatingly registers the darkfield recordings of the surface, and that a digital image processing device (48) pointwise subtracts the digitized recordings.

9. Arrangement as claimed in Claim 6, characterized in that the surface to be tested is raster-scanned by a laser beam focussed thereon by focussing optics (7), and that simultaneously the darkfield reflection signal and the darkfield transmission signal of each image point is applied to photodetectors (35a, 35b) which generate output signals for a difference circuit (36) with a threshold circuit (37) arranged in series thereto.

10. Arrangement as claimed in claim 9, characterized in that the darkfield signals of the tested image point are transported via optical fibers (33, 34) to the photodetectors (35), and that the ends of the optical fibers are arranged annularly behind the focussing optics (7) in such a manner that the darkfield reflection light passes through the focussing optics (7).

11. Arrangement as claimed in any one of Claims 7 or 8, characterized in that the value of the output signal fo the threshold circuit (37) is stored in a digital storage (38) which is addressed in accordance with the actual position of the scanning laser beam.

12. Arrangement as claimed in any one of Claims 9 to 11, characterized in that for deflecting a linearly polarized beam (40) an oscillating mirror (43) oriented substantially vertically to the beam axis is provided which is arranged in series with a polarizing beam splitter (41) oriented at 45° to the beam axis, and a λ/4 plate (42).

## Revendications

1. Procédé pour contrôler la présence éventuelle de défauts ayant des dimensions de la taille du micron, dans des surfaces, moyennant l'utilisation d'un éclairage sur fond noir, caractérisé en ce que pour chaque point de la surface, on soustrait l'intensité lumineuse produite dans le cas d'un éclairage sur fond noir par réflexion, de l'intensité lumineuse que l'on obtient lors d'un éclairage supplémentaire sur fond noir avec d'autres paramètres optiques, et qu'on compare la différence à une valeur de seuil.

2. Procédé selon la revendication 1, caractérisé en ce que la différence des intensités lumineuses est utilisée comme mesure de la taille du défaut.

3. Procédé selon la revendication 1 ou 2, caractérisé en ce que, lors du contrôle des surfaces de corps transparents, on exécute un éclairage supplémentaire sur fond noir en lumière transmise.

4. Procédé selon la revendication 3, caractérisé par son utilisation pour contrôler l'absence éventuelle de particules parasites déposées, dans des masques photolithographiques transparentes.

5. Procédé selon la revendication 1 ou 2, caractérisé en ce qu'on exécute l'éclairage supplémentaire sur fond noir par réflexion, sous un angle d'éclairage différent de l'angle du premier éclairage sur fond noir par réflexion.

6. Dispositif pour contrôler la présence éventuelle de défauts possédant des dimensions de l'ordre du micron, dans des surfaces, et dans lequel des dispositifs (6; 33) sont prévus pour produire un éclairage sur fond noir par réflexion, caractérisé par:
- des dispositifs (8; 34) servant à produire un éclairage supplémentaire sur fond noir, dont les paramètres optiques diffèrent de ceux de l'éclairage sur fond noir par réflexion,
- des dispositifs (36) pour soustraire les deux intensités lumineuses, que chaque point d'image émet sous l'influence des deux éclairages sur fond noir, et
- des dispositifs pour mettre en œuvre une comparaison de la différence des intensités lumineuses par rapport à une valeur de seuil.

7. Dispositif selon la revendication 6, caractérisé en ce que les dispositifs servant à réaliser l'éclairage sur fond noir sont des fibres optiques (43, 44, 66, 67), dont les extrémités sont disposées selon une disposition annulaire par rapport à l'axe optique du système de formation d'images (7, 8).

8. Dispositif selon la revendication 7, caractérisé en ce qu'une caméra vidéo (45) enregistre en alternance les deux enregistrements de la surface sur fond noir et qu'un dispositif numérique (48) de traitement d'images soustrait les intensités numérisées de chaque point d'image.

9. Dispositif selon la revendication 6, caractérisé en ce que la surface devant être examinée est balayée selon un balayage de trame par un faisceau laser qui est focalisé sur la surface par un dispositif optique de focalisation (7), et que le signal obtenu sur fond noir par réflexion et le signal obtenu sur fond noir par transmission de chaque point d'image sont envoyés simultanément à des photodétecteurs (35a, 35b) qui produisent des signaux de sortie pour un circuit soustracteur (36) en aval duquel est branché un circuit à valeur de seuil (37).

10. Dispositif selon la revendication 9, caractérisé en ce que les signaux obtenus sur fond noir du point d'image examiné sont transmis par l'intermédiaire de fibres optiques (33, 34) aux photodétecteurs (35) et que les extrémités des fibres optiques sont disposées selon une disposition annulaire en arrière du dispositif optique de focalisation (7) de sorte que la lumière transmise sur fond noir par réflexion traverse le dispositif de focalisation.

11. Dispositif selon la revendication 7 ou 8, caractérisé en ce que la valeur du signal de sortie du circuit à valeur de seuil (37) est mémorisée dans une mémoire numérique (38) qui est adressée conformément à la position instantanée du faisceau de rayonnement laser exécutant l'exploration par balayage.

12. Dispositif selon l'une des revendications 9 à 11, caractérisé en ce que pour faire dévier un faisceau de rayonnement (40) polarisé linéairement, il est prévu un miroir oscillant (43) orienté sensiblement perpendiculairement à l'axe du faisceau et en amont duquel sont branchés un diviseur de rayonnement (41) produisant une polarisation et orienté à 45° par rapport à l'axe du faisceau, et une lame quart-d'onde (42).

FIG. 1

FIG. 3

FIG. 2A

FIG. 2 B

FIG. 4

FIG. 6

FIG. 5